# EUROPÄISCHE PATENTSCHRIFT

(11) **EP 2 203 795 B1**
(45) Veröffentlichungstag und Bekanntmachung des Hinweises auf die Patenterteilung: **28.06.2017**
(21) Anmeldenummer: 08803458.2
(22) Anmeldetag: 01.09.2008
(51) Int. Cl.: G06F 1/26, G01R 31/36, H03M 1/10, G01R 31/3167

(54) **FAHRZEUG-STEUEREINHEIT MIT EINEM VERSORGUNGSPANNUNGSÜBERWACHTEN MIKROCONTROLLER SOWIE ZUGEHÖRIGES VERFAHREN**
VEHICLE CONTROL UNIT HAVING A MICROCONTROLLER THE SUPPLY VOLTAGE OF WHICH IS MONITORED AND ASSOCIATED METHOD
UNITÉ DE COMMANDE DE VÉHICULE COMPRENANT UN MICROCONTRÔLEUR POURVU D'UN SYSTÈME DE CONTRÔLE DES TENSIONS D'ALIMENTATION ET PROCÉDÉ CORRESPONDANT

(30) Priorität: 24.09.2007 DE 102007045509
(43) Veröffentlichungstag der Anmeldung: 07.07.2010
(73) Patentinhaber: Continental Automotive GmbH, 30165 Hannover (DE)
(72) Erfinder: FROSCHHAMMER, Alexander, 93059 Regensburg (DE); KICK, Marco, 71394 Kernen (DE); LENHART, Rainer, 93049 Regensburg (DE); PROCHAZKA, Gerhard, A-1170 Wien (AT); SCHINKOWITSCH, Bernhard, A-2264 Sierndorf/March (AT)
(86) Internationale Anmeldenummer: PCT/EP2008/061475
(87) Internationale Veröffentlichungsnummer: WO 2009/040216

(56) Entgegenhaltungen:
- WO-A-03/085834
- WO-A-2005/003972
- WO-A-2005/109650
- DE-C1- 4 422 992
- US-A1- 2002 154 016

## Beschreibung

Fahrzeug-Steuereinheit mit einem Versorgungspannungsüberwachten Mikrocontroller sowie zugehöriges Verfahren Die Erfindung betrifft eine Fahrzeug-Steuereinheit mit einem Mikrocontroller, an den mehrere analoge Versorgungsspannungen angelegt sind, und mit einer Überwachungseinheit zur Funktionsüberwachung des Mikrokontrollers gemäss den Merkmalen wie im unabhängigen Anspruch 1 angegeben. Neuere Mikrocontroller (µCs), die in elektronischen Fahrzeug-Steuergeräten wie zum Beispiel Motorsteuergeräten, Getriebesteuergeräten, Kontrolleinheiten im Chassis-Bereich von Kraftfahrzeugen, usw. verwendet werden, sind jeweils gleichzeitig durch mehrere Versorgungsspannungen - wie zum Beispiel von 1,5V und 3,3V - versorgt. Eine einwandfreie, korrekte Betriebs- und Funktionsweise des jeweiligen Mikrocontrollers, insbesondere von auf ihm ablaufenden Applikationen bzw. Rechenprozeduren, sind dann sichergestellt, wenn diese Versorgungsspannungen weitgehend stabil sind, d.h. innerhalb zugehöriger, definierter Toleranzbänder bleiben. Dies wird anhand einer Spannungswachung fortlaufend überprüft. Typischerweise wurden bisher zur Spannungsüberwachung spezifische Hardware-Spannungsüberwachungsgeräte verwendet. Diese werden in der Praxis als sogenannte "watch dogs" bezeichnet. Derartige Hardware-Überwachungsgeräte sind zum einen relativ teuer, wenn sie mit ausreichender Präzision bzw. Genauigkeit arbeiten. Zum anderen ist wegen der Hardware-Realisierung eines derartigen Spannungsüberwachungsgeräts dessen Parametrisierung und Flexibilität für die Praxis oftmals zu begrenzt oder zu eingeschränkt. Daher offenbart die WO 2005/109650 zu überwachende analoge Versorgungsspannungen mittels A/D Wandler zu digitalisieren. Ein Mikroprozessor überprüft dann ob diese digitalisierten Werte in einem Toleranzbereich liegen.

Die WO 03/085834 lehrt eine fehlerhafte Referenzspannung eines A/D Wandlers zu erkennen. Dazu wandelt sie ein Testsignal mit zwei Referenzspannungen. Die so erhaltenen Werte werden einem Quervergleich unterzogen. Gemäss dem Verfahren der D4 wird der Fehlerfall sich zweier im selben Verhältniss ändernder Referenzspannungen nicht erkannt. Der Erfindung liegt die Aufgabe zu Grunde, eine Fahrzeug-Steuereinheit mit einem Mikrocontroller bereitzustellen, dessen mehrere analoge Versorgungsspannungen in einfacherer Weise als durch spezifisch zugeordnete, rein hardwaremäßig realisierte "watch dogs" bei gleichzeitig ausreichender Funktionssicherheit überwacht werden können. Diese Aufgabe wird bei einer Fahrzeug-Steuereinheit der eingangs genannten Art gelöst gemäss den Merkmalen wie im unabhängigen Anspruch 1 angegeben. Dadurch, dass in einem rechentechnisch abgesicherten Bereich des Mikrocontrollers die mehreren analog/digital gewandelten Versorgungsspannungen des Mikrocontrollers mittels ein oder mehrerer Schwellwertvergleichs- Operationen - bzw. Prozeduren dahingehend überwacht werden, ob sie innerhalb vorgegebener, spezifischer Toleranzbereiche liegen, ist eine Kontrolle bzw. ein "Monitoring" bestimmter gewünschter Spannungswerte für die mehreren Versorgungsspannungen unter Einsparung von Hardware-Monitoringeinheiten mit ausreichender Überwachungssicherheit individuell, d.h. spezifisch ermöglicht. Trotz des Fehlens eigener Hardware-Monitoreinheiten zur Spannungsüberwachung der mehreren analogen Versorgungsspannungen des Mikrocontrollers erlaubt das "softwaremäßige Monitoring" der Versorgungsspannungen nach deren A/D-Wandlung, d.h. Digitalisierung, verlässliche Informationen darüber, wie stabil bzw. robust die analogen Versorgungsspannungen des Mikrocontrollers tatsächlich eingehalten werden. Dazu trägt insbesondere die Überwachung dieser digitalisierten Versorgungsspannungen in einem rechentechnisch abgesicherten Bereich des Mikrocontrollers bei, so dass Auswertefehler der digitalisierten, gemessenen Versorgungsspannungen weitgehend vermieden sind. Diese Diagnosesicherheit ist insbesondere vorteilhaft bei Fahrzeug-Steuereinheiten wie zum Beispiel Motorsteuerungen, Getriebesteuerungen oder sonstigen sicherheitsrelevanten Steuergeräten wie zum Beispiel im Chassisbereich, bei denen eine hohe Verfügbarkeit gefordert ist, d.h. ein Ausfall während des Fahrbetriebs intolerable bzw. unzulässig ist. Verglichen mit reinen Hardware- "watch dog" Lösungen erlaubt diese "softwaremäßige Überwachung" der digitalisierten Versorgungsspannungen in einem abgesicherten Rechenbereich des Mikrocontrollers eine höhere Flexibilität, wie zum Beispiel hinsichtlich einzuhaltender Toleranzbereich bzw. Toleranzbänder für die zu überwachenden Versorgungsspannungen, um eine geeignete Balance bzw. Ausgeglichenheit zwischen Überwachungssicherheit und Verfügbarkeit des Gesamtsystems der Fahrzeug-Steuereinheit weitgehend sicherstellen zu können.

Die Erfindung betrifft auch ein Verfahren zur Überwachung mehrerer analoger Versorgungsspannungen, gemäss den Merkmalen wie im unabhängigen Anspruch 6 angegeben.

Sonstige Weiterbildungen der Erfindung sind in den Unteransprüchen wiedergegeben.

Die Erfindung und ihre vorteilhaften Weiterbildungen werden nachfolgend anhand von Zeichnungen näher erläutert.

Es zeigen:
- Figur 1: in schematischer Darstellung ein Ausführungsbeispiel einer erfindungsgemäßen Fahrzeug-Steuereinheit, und
- Figur 2: in schematischer Darstellung als Einzelheit der Steuereinheit von Figur 1 die spannungsmäßige Verschaltung zwischen deren Mikrocontroller und einer zugeordneten Hardware-Überwachungseinheit.

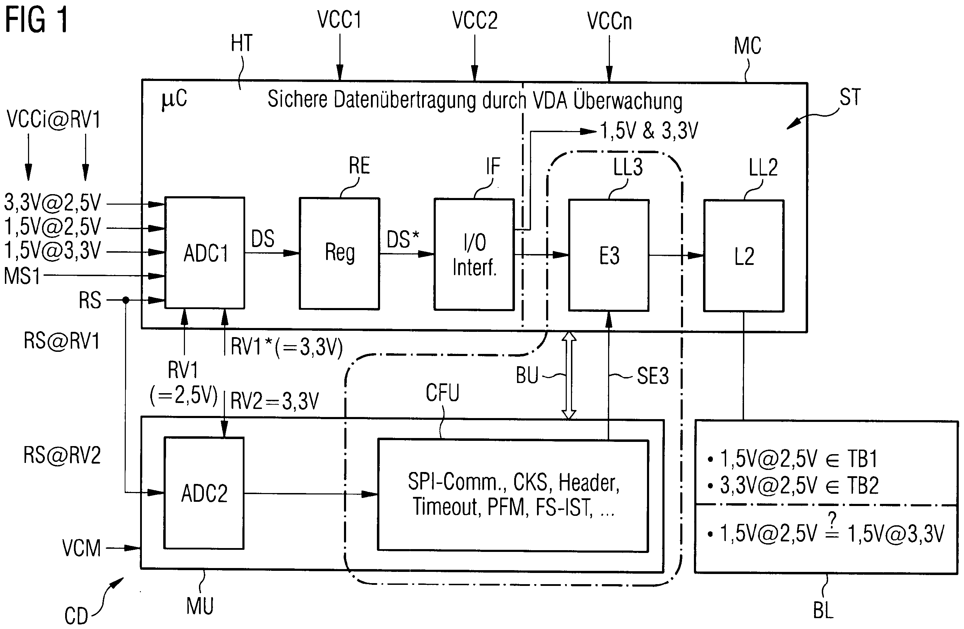

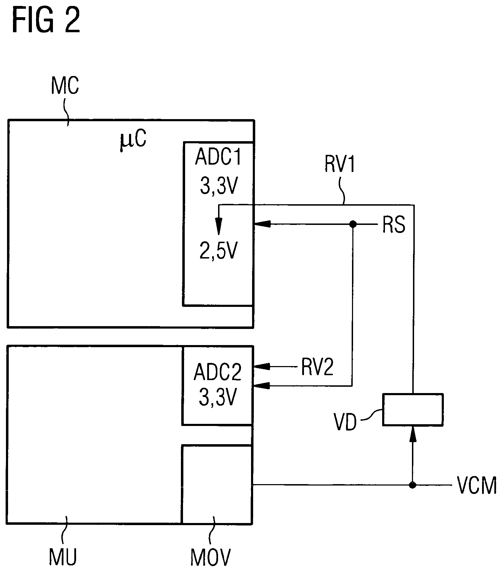

Elemente mit gleicher Funktion und Wirkungsweise sind in den Figuren 1 und 2 jeweils mit denselben Bezugszeichen versehen.

Die Figur 1 zeigt in schematischer Darstellung den Aufbau und die Funktionsweise einer beispielhaften Fahrzeug-Steuereinheit CD mit einem Mikrocontroller MC, dessen mehrere von analogen Versorgungsspannungen VCC1 mit VCCn nach dem erfindungsgemäßen Überwachungskonzept auf Stabilität "gemonitort" bzw. überwacht, d.h. dahingehend überprüft werden, ob sie spezifisch vorgegebene Spannungswerte innerhalb akzeptabler, d.h. vordefinierter Toleranzbänder einhalten. Die Fahrzeug-Steuereinheit ist insbesondere durch ein Motorsteuergerät für einen Verbrennungsmotor gebildet. Zur Funktionskontrolle ist der Mikrocontroller MC über ein Bussystem BU mit einer einzelnen Hardware-Überwachungseinheit MU gekoppelt. Der Mikrocontroller MC weist eingangsseitig einen Analog-/Digital (abgekürzt A/D)-Wandler ADC1 auf. Mit dessen Hilfe lässt sich der Pegelverlauf mindestens eines auszuwertenden, analogen Messsignals MS1 in zugehörige Digitalwerte DS umsetzen bzw. umwandeln. Das Messsignal MS1 wird vorzugsweise von mindestens einer Fahrzeugkomponente, wie z.B. dem Gaspedal eines Kraftfahrzeugs, erzeugt und an den Analog-/Digital-Wandler ADC1 des Mikrocontrollers MC geliefert. Vom Analog-/Digital-Wandler ADC1 werden die erzeugten Digitalwerte DS an ein nachgeordnetes Register RE zur Zwischenspeicherung ausgegeben. Vom Register bzw. Zwischenspeicher RE werden die dort zwischengepufferten Digitalwerte an ein Ein-/ Ausgabe-Interface (1/0-Interface) IF weitergeleitet. Sie sind in der Figur 1 mit DS* bezeichnet. Das I/O- Interface dient als Schnittstelle zwischen den peripheren Komponenten und dem Funktionsrechner ST des Mikrocontrollers MC, wo dessen Betriebs- und Verarbeitungssoftware implementiert ist. Der Funktionsrechner ST weist zur Rechnerüberwachung eine sogenannte L3-Ebene bzw. L3-Schicht LL3 auf. Unter Rechnerüberwachung wird dabei das korrekte Zusammenwirken von Soft- und Hardwarestrukturen des Mikrocontrollers MC verstanden, deren Topologie die Erkennung von fehlerhaften Operationen des Funktionsrechners (Rechnerkern, betroffene Bereiche im RAM/ROM) ermöglicht. Im Funktionsrechner erfolgt zweckmäßigerweise generell die Überwachung der Speicherbausteine RAM/ROM mindestens einmal pro Fahrzyklus vor Motorstart (Initialisierung oder vorangegangener Nachlauf). Insbesondere wird bei entdeckten Fehlern der Motorstart in jedem Fall in der Initialisierung erneut durchgeführt. Der Motorstart (falls softwaregesteuert) bzw. die Verbrennung im jeweiligen Zylinder des Motors erfolgt vorzugsweise erst nach Abschluss der Überprüfung im fehlerfreien Zustand. Die L3-Schicht LL3 umfasst insbesondere zwei Grundelemente. Ein erstes Grundelement ist durch eine Überwachungssoftware E3 im Funktionsrechner ST gebildet. Diese kommuniziert über eine Schnittstelle SE3 mit einer vom Mikrocontroller MC physikalisch unabhängigen Überwachungseinheit MU als zweites Grundelement. Die Überwachungseinheit bzw. das Überwachungsmodul MU ist vorzugsweise durch eine separate Hardwareeinheit realisiert. Sie dient der Funktionsüberwachung des Funktionsrechners ST des Mikrocontrollers MC. Insbesondere ist das Überwachungsmodul MU als Überwachungsrechner ausgebildet. Es stellt der Überwachungssoftware E3 im Funktionsrechner ST des Mikrocontrollers MC vorzugsweise zyklisch eine Frage aus einer Menge von diversitären Fragen, überwacht den Empfang eines zyklischen Prüfergebnisses, das vom Funktionsrechner ST aufgrund der jeweils übermittelten Frage errechnet wird, bewertet dieses Prüfergebnis und leitet im Fehlerfall eine Fehlerreaktion des Funktionsrechners ST ein. Das Überwachungsmodul MU kann vorzugsweise als ASIC oder Rechner ausgeführt sein. Das Überwachungsmodul MU fungiert als sogenannter "watch dog" zur Funktionskontrolle bzw. dem Monitoring der rechentechnischen Abläufe des Funktionsrechners ST. Seine Rechen-/Logikeinheit, die dieses Monitoring der Rechenfunktionen des Funktionsrechners ST durchführt, ist in der Figur 1 durch eine Block CFU gekennzeichnet. Im Einzelnen werden von dieser Rechen-/Logikeinheit CFU eine SPI-Kommunikation, d.h. "Serial Peripheral Interface-Kommunikation" zur L3-Schicht LL3 im Funktionsrechner ST bereitgestellt, für die Datenübertragung über die Schnittstelle SE3 eine Checksum ("CKS")-Überprüfung, eine sogenannte Headerkontrolle, eine Timer-Out-Kontrolle, ein "Program Flow Monitoring", d.h. eine Programmablaufkontrolle, eine Logiküberwachung, ein funktionsspezifischer Befehlssatztest ("FS-IST" = "function specific instruction set test") durchgeführt. Allgemein ausgedrückt wird also eine zeitbasierte und auch inhaltliche Überwachung der Rechenprozesse des Funktionsrechners ST mit Hilfe der Logikeinheit CFU des Überwachungsmoduls MU durchgeführt. Das Zusammenwirken zwischen dem unabhängigen Überwachungsmodul MU und der Überwachungssoftware E3 in der L3-Ebene LL3 des Funktionsrechners ST wird als sogenannte Frage-Antwort-Kommunikation bezeichnet. Dabei werden insbesondere mehrere Testpfade im Funktionsrechner abgearbeitet. Jeder Testpfad liefert ein exakt definiertes frageabhängiges numerisches Teilergebnis. Die Verknüpfung der Teilergebnisse führt zu einem numerischen Gesamtergebnis (Prüfergebnis), welches per Kommunikationsschnittstelle bzw. Interface SE3 an das Überwachungsmodul MU übertragen wird. Die Überwachungssoftware E3 im Funktionsrechner ST signalisiert der Logikeinheit CFU im Überwachungsmodul MU durch richtige Antworten den rechentechnisch fehlerfreien Betrieb.

Durch diese Überwachungssoftware E3 in der L3-Schicht LL3 des Funktionsrechners ST kann dort ein rechentechnisch abgesicherter Rechenbereich LL2 bereitgestellt werden. In diesem rechentechnisch abgesicherten Bereich LL2 des Funktionsrechners ST können insbesondere sicherheitsrelevante Funktionalitäten berechnet werden.

Der abgesicherte Rechenbereich LL2 sowie die Rechnerüberwachungsebene LL3 sind vorzugsweise durch eine sogenannte L2-Schicht sowie L3-Schicht gemäß standardisiertem E-Gas-Überwachungskonzept von Otto- und Dieselmotoren gebildet.

Um nun die mehreren analogen Versorgungsspannungen VCC1 mit VCCn des Mikrocontrollers MC ohne weitere Hardware-Überwachungsmodule bzw. "watch dogs", d.h. lediglich mit der sowieso schon vorhandenen Überwachungseinheit MU, die der rechentechnischen Funktionskontrolle des Funktionsrechners ST dient, auf Stabilität bezüglich zugeordneter, einzuhaltender Spannungswerte überwachen zu können, werden die analogen Versorgungsspannungen VCC1 mit VCCn an den mindestens einen Eingangsport des Analog-/Digital-Wandlers ADC1 des Mikrocontrollers MC angelegt und in digitale Versorgungsspannungen umgewandelt. Die digitalisierten Versorgungsspannungen werden danach im abgesicherten Rechenbereich LL2 des Funktionsrechners ST ausgewertet und dahingehend überwacht, ob sie vorgegebenen digitalen Spannungswerten innerhalb vordefinierter Toleranzbänder entsprechen. Dadurch, dass in einem rechentechnisch abgesicherten Bereich des Funktionsrechners des Mikrocontrollers die mehreren analog-/digitalgewandelten Versorgungsspannungen des Mikrocontrollers mittels ein oder mehrerer Schwellwertvergleichs-Prozeduren dahingehend überwacht werden, ob sie gewünschte digitale Spannungswerte ohne unzulässige Abweichungen einhalten, ist eine Kontrolle bzw. ein Monitoring der mehreren analogen Versorgungsspannungen ohne zusätzliche Hardware-Überwachungseinheiten mit ausreichender Diagnosesicherheit individuell, d.h. spezifisch ermöglicht. Trotz des Fehlens eigener Hardware-Monitoreinheiten zur Spannungsüberwachung der mehreren analogen Versorgungsspannungen des Mikrocontrollers erlaubt das softwaremäßige Monitoring der Versorgungsspannungen nach deren A/D-Wandlung, d.h. Digitalisierung, verlässliche Informationen darüber, wie stabil bzw. robust die analogen Versorgungsspannungen des Mikrocontrollers tatsächlich eingehalten werden. Insbesondere trägt die Überwachung dieser digitalisierten Versorgungsspannungen in dem rechentechnisch abgesicherten Bereich LL2 des Funktionsrechners ST dazu bei, dass Auswertefehler der digitalisierten gemessenen Versorgungsspannungen weitgehend vermieden sind. Diese Diagnosesicherheit ist insbesondere bei Fahrzeug-Steuereinheiten wie z.B. Motorsteuerungen, Getriebesteuerungen oder sonstigen sicherheitsrelevanten Steuergeräten wie z.B. im Chassisbereich vorteilhaft, bei denen eine hohe Verfügbarkeit gefordert ist, d.h. ein Ausfall während des Fahrbetriebs inakzeptabel bzw. unzulässig ist. Verglichen mit reinen Hardware- bzw. "watch dog"-Lösungen erlaubt diese "softwaremäßige" Überwachung der digitalisierten Versorgungsspannungen in einem abgesicherten Rechenbereich des Mikrocontrollers eine höhere Flexibilität, wie z.B. hinsichtlich einzuhaltender Toleranzbereiche bzw. Toleranzbänder für die zu überwachenden Versorgungsspannungen, um eine geeignete Balance bzw. Ausgeglichenheit zwischen Überwachungssicherheit und Verfügbarkeit des Gesamtsystems der Fahrzeug-Steuereinheit weitgehend sicherstellen zu können.

Hier im Ausführungsbeispiel von Figur 1 sind drei Versorgungsspannungen VCCi mit i = 1, 2, 3 an den mindestens einen Eingang des Analog-/Digital-Wandlers ADC1 des Mikrocontrollers MC gelegt. Im Einzelnen ist dies die Versorgungsspannung VCC1 = 3,3 V, die Versorgungsspannung VCC2 = 1,5 V sowie die Versorgungsspannung VCC3 = 1,5 V.

Der Analog-/Digital-Wandler ADC1 des Mikrocontrollers MC ist mit einer Referenzspannung RV1 beaufschlagt, durch die der Abstand zwischen zwei ausgegebenen Digitalwerten festgelegt wird. Bei einer Referenzspannung von z.B. 2,5 V beträgt bei einem 8 Bit-A/D-Wandler der Abstand zwischen zwei aufeinanderfolgenden digitalen Codewörtern also 2,5 V/ 256 = 0,01 V. Durch die Referenzspannung eines Analog-/Digitalwandlers wird die Schritthöhe und damit die Skalierung des Wertebereichs seiner darstellbaren Codewörter (=Digitalwerte) festgelegt. Hier im Ausführungsbeispiel kann der Analog-/Digital-Wandler ADC1 sowohl mit einer Referenzspannung RV1 = 2,5 V als auch mit einer Referenzspannung RV1* = 3,3 V referenziert werden. Allgemein ausgedrückt kann der Analog-/Digital-Wandler ADC1 des Mikrocontrollers MC mit mindestens zwei verschiedenen Referenzspannungen RV1 betrieben werden. Es kann also die Analog-/Digital-Wandlung des A/D-Wandlers ADC1 auf mindestens zwei verschiedene Referenzspannungswerte bezogen sein. Ein erster Referenzspannungswert, wie hier z.B. RV1 = 2,5 V für den A/D-Wandler ADC1 wird vorzugsweise direkt oder indirekt mittels einer spezifisch zugeordneten Hardware-Monitoreinheit hardwaremäßig überwacht. Diese Hardware-Monitoreinheit ist hier im Ausführungsbeispiel von Figur 1 durch eine Kontrolleinheit MOV gebildet, die der Spannungsüberwachung der Versorgungsspannung VCM der Hardware- Überwachungseinheit MU dient. Diese Einzelheit ist in der Figur 2 vergrößert sowie schematisch dargestellt. Die mittels der spezifischen Hardware-Monitoreinheit MOV hardwaremäßig überwachte Versorgungsspannung VCM der Überwachungseinheit MU stellt über mindestens einen Spannungsteiler VD dem A/D-Wandler ADC1 des Mikrocontrollers einen gewünschten, ersten Referenzspannungswert, hier RV1 = 2,5 V, bereit. Auf diese Weise ist dieser erste Referenzspannungswert des A/D-Wandlers ADC1 indirekt auch hardwaremäßig spannungsüberwacht. Es kann sichergestellt werden, dass die am A/D-Wandler ADC1 angelegte Referenzspannung RV1 diesen Spannungswert von 2,5 V sicher innerhalb vordefinierter Toleranzbereiche einhält. Bezogen auf diesen hardwaremäßig abgesicherten Referenzspannungswert kann dann auch in zuverlässiger Weise im rechentechnisch abgesicherten Bereich LL2 des Funktionsrechners ST überprüft werden, ob die Digitalwerte DS, die der A/D-Wandler ADC1 bezogen auf diese abgesicherte Referenzspannung RV1 = 2,5 V für die eingangsseitig zur Stabilitätskontrolle angelegten, analogen Versorgungsspannungen VCC1 mit VCCn, wie hier z.B. VCC1=3,3 V sowie VCC2 = 1,5 V, ausgibt, innerhalb vorgegebener Toleranzbereiche TB1, TB2 liegen. In der Figur 1 ist die Kombination von jeweilig angelegter, analoger Versorgungsspannung VCCi und jeweilig am A/D-Wandler ADC1 anliegender Referenzspannung RV1 durch ein @-Zeichen symbolisiert. In der rechentechnisch abgesicherten Schicht LL2 des Funktionsrechners ST werden die Digitalwerte DS der Vielzahl von Versorgungsspannungen VCCi wie hier VCC1, VCC2 dahingehend überwacht, ob sie innerhalb vorgegebener Toleranzbereiche - wie hier TB1, TB2 - für die beiden zu kontrollierenden Versorgungsspannungen VCC1, VCC2 liegen. Dies ist in der Figur 1 durch ein ε-Symbol im Block BL symbolisiert.

Wird der A/D-Wandler ADC1 mit einem zweiten Referenzspannungswert RV1* = 3,3 V referenziert, so kann ohne weitere Hardware-Absicherung dieser Referenzspannungswert auf Stabilität überprüft werden, indem dieselbe analoge Versorgungsspannung wie z.B. VCC2 = 1,5 V an den A/D-Wandler ADC1 in Bezug auf den ersten Referenzspannungswert RV1 = 2,5 V sowie auf den zweiten Referenzspannungswert RV1* = 3,3 V angelegt wird und die sich dabei ergebenden Digitalwerte im rechentechnisch abgesicherten Bereich LL2 des Funktionsrechners ST miteinander verglichen, d.h. in Relation zueinander gesetzt werden. Wenn sich die beiden Digitalwerte für dieselbe Versorgungsspannung, wie z. B. VCC2 = 1,5 V, die auf die beiden unterschiedlichen Referenzspannungswerte RV1 = 2,5 V sowie RV1* = 3,3 V im selben Verhältnis zueinander stehen, wie die beiden verschiedenen Referenzspannungswerte RV1 = 2,5 V sowie RV1* = 3,3 V zueinander, so ergibt die Überprüfung in der LL2-Schicht des Funktionsrechners ST, dass der A/D-Wandler ADC1 auch für die unabgesicherte zweite Referenzspannung RV1* = 3,3 V korrekt, d.h. genau arbeitet. Es wird also in der LL2-Schicht kontrolliert bzw. plausibilisiert, ob sich dieselbe Beziehung zwischen den Digitalwerten, die der A/D-Wandler ADC1 für dieselbe angelegte Versorgungsspannung wie hier z.B. VCC2=1,5V bei den beiden verschiedenen Referenzspannungen RV1 = 2,5 V sowie RV1 = 3,3 V erzeugt, wie zwischen den angelegten Referenzspannungen RV1 = 2,5 V sowie RV1* = 3,3 V einstellt. Damit ist in einfacher Weise eine zuverlässige Genauigkeitsprüfung auch der zweiten, ungesicherten Referenzspannung RV1 = 3,3 V des A/D-Wandlers ADC1 durch eine Vergleichsoperation innerhalb der LL2-Schicht des Funktionsrechners ST ermöglicht. Die in der LL2-Schicht insgesamt durchgeführten Spannungsüberprüfungen sind in der Figur 1 im Block BL für das vorliegende Ausführungsbeispiel visualisiert.

Zur Funktionsüberprüfung des Gesamtwertebereichs des A/D-Wandlers ADC1 des Mikrocontrollers MC wird in der LL2-Schicht des Funktionsrechners ST zweckmäßigerweise eine weitere Vergleichsoperation durchgeführt. Dazu wird zum einen ein sich dynamisch veränderndes Referenzsignal RS an den Eingang des ersten A/D-Wandlers ADC1 des Mikrocontrollers MC angelegt und dieser mit seiner hardwaremäßig abgesicherten Referenzspannung RV1 = 2,5 V beaufschlagt. Zum anderen wird ein redundant zum ersten A/D-Wandler ADC1 vorhandener, zweiter Analog-/Digital-Wandler mit demselben, sich dynamisch verändernden Referenzsignal RS beaufschlagt. Dieser zweite Analog-/Digitalwandler ist insbesondere durch den Analog-/Digitalwandler ADC2 der Überwachungseinheit MU gebildet. Dieser redundante A/D-Wandler ADC2 ist mit einer ungesicherten Referenzspannung RV2 =3,3 V beaufschlagt ist. Dem abgesicherten Rechenbereich LL2 des Funktionsrechners ST sind somit Digitalwerte des Referenzsignals bzw. Probensignals RS vom mit der abgesicherten Referenzspannung RV1 betriebenen A/D-Wandler ADC1 des Mikrocontrollers MC und Digitalwerte des Referenzsignals RS vom mit der ungesicherten Referenzspannung RV2 betriebenen A/D-Wandler ADC2 der Überwachungseinheit MU zum Quervergleich bereitgestellt. Wenn die Digitalwerte für ein- und dasselbe Referenzsignal bzw. Probensignal RS, die vom A/D-Wandler ADC1, der mit der abgesicherten Referenzspannung RV1 referenziert ist, und vom zweiten A/D-Wandler ADC2, der mit der ungesicherten Referenzspannung RV2 referenziert ist, erzeugt werden, innerhalb vorgebbarer Toleranzgrenzen im selben Verhältnis wie die Referenzspannungswerte RV1, RV2 zueinander stehen, dann ergibt die Überprüfung in der LL2-Schicht des Funktionsrechners ST, dass der A/D-Wandler ADC1 des Mikrocontrollers MC nicht nur punktuell sondern über seinen gesamten Dynamikbereich einwandfrei funktioniert. Dafür genügt also der vorstehend angegebene einfache, quervergleichende Plausibilitätstest. Andernfalls liegt eine Fehlfunktion des A/D Wandlers ADC1 des Mikrocontrollers MC vor.

Zusammenfassend betrachtet wird zur Überwachung der Stabilität mehrerer Versorgungsspannungen, die an einen Mikrocontroller angelegt sind, ein rechentechnisch abgesicherter Funktionsbereich des Funktionsrechners des Mikrocontrollers bereitgestellt und genutzt, indem durch Analog/Digital-Wandlung erzeugte Digitalwerte der analogen Versorgungsspannungen dahingehend überprüft werden, ob sie innerhalb spezifisch zugeordneter, zulässiger Toleranzbänder liegen. Um diesen rechentechnisch abgesicherten Funktionsbereich im Mikrocontroller zu erzeugen, sind insbesondere folgende Komponenten zweckmäßig:
- ein "gemonitorter" bzw. referenzspannungsüberwachter A/D-Wandler, um die hinsichtlich ihrer Stabilität zu überwachenden, analogen Versorgungsspannungen in Digitalwerte umzuwandeln, die von der Ablauflogik im Funktionsrechner des Mikrocontrollers verarbeitet werden können; insbesondere kann dabei die Ablauflogik durch Software implementiert sein.
- eine "gemonitorte", d.h. hardwaremäßig spannungsüberwachte Referenzspannung für die A/D-Wandlung des A/D-Wandlers und des Mikrocontrollers, um durch eine fehlerhafte Bezugsgröße Fehlereinträge von Außen auf die A/D-Wandlung zu vermeiden;
- rechentechnisch abgesicherte Berechnungen im Funktionsrechner des Mikrocontrollers; diese rechentechnischen Absicherungen können insbesondere funktionsspezifische Befehlssatztests, eine Ablaufüberwachung, und/ oder zyklische RAM/ ROM-Tests umfassen;
- mindestens eine Auslöse- bzw. Triggereinheit, um einen "Reset" des Mikrocontrollers zu ermöglichen; damit kann der Mikrocontroller in einen sicheren Zustand gebracht werden und sich von Fehlern erholen, wenn die analogen Versorgungsspannungen des Mikrocontrollers außerhalb der ihnen spezifisch zugeordneten, vorgegebenen Toleranzbereiche bzw. Toleranzbänder wie z. B. TB1, TB2 gelegen sind und deshalb ein einwandfreier Betrieb des Mikrocontrollers nicht möglich gewesen ist.

In der rechentechnisch abgesicherten Umgebung des Funktionsrechners ST werden vorzugsweise folgende Abläufe implementiert, die:
- die digitalisierten Versorgungsspannungen lesen;
- Schwellwertvergleiche durchführen, um zu Überprüfen, ob der Digitalwert der jeweilig zu überwachenden Versorgungsspannung innerhalb eines vorgegebenen oder berechneten Toleranzbereichs liegt, innerhalb dem jeweils die jeweilige Versorgungsspannung als weitgehend stabil betrachtet wird;
- nach Spannungsentprellung ("potential debouncing") werden ggf. entsprechende Fehlerreaktionen getriggert, wenn eine Abweichung für die jeweilig zu überwachende Versorgungsspannung von einem vorgegebenen Toleranzbereich entdeckt bzw. registriert wird, d.h. wenn ein spezifisch zugeordneter oberer oder unterer Schwellwert nach oben oder unten überschritten wird;
- wenn mehr als eine Versorgungsspannung zu überwachen ist, kann es zweckmäßig sein, den Analog-/Digital-Wandler des Mikrocontrollers mit verschiedenen Referenzspannungen zu referenzieren; wegen der dadurch verbesserten Skalierbarkeit des Wertebereichs des A/D-Wandlers kann die Detektionsfähigkeit des A/D-Wandlers, d.h. dessen Genauigkeit erhöht werden.

Auf diese Weise können mehrere Versorgungsspannungen des Mikrocontrollers lediglich mit einer einzigen Hardware abgesicherten Referenzspannung auf Stabilität überwacht werden, ohne dass es erforderlich ist, für jede zu überwachende Versorgungsspannung des Mikrocontrollers eigens eine eigene Hardware-Monitoring-Einheit vorzusehen. Abweichungen der zu überwachenden, analogen Versorgungsspannungen können durch Auswertung der zugehörigen Digitalwerte in einem rechentechnisch abgesicherten Funktionsbereich des Funktionsrechners des Mikrocontrollers detektiert werden, indem die Digitalwerte dahingehend kontrolliert werden, ob sie innerhalb vorgegebener, spezifisch zugeordneter Toleranzbereiche liegen.

Fehlberechnungen des Mikrocontrollers, die zu unentdeckten Fehlern bei den Schwellwertvergleichen für die Digitalwerte der hinsichtlich ihrer Langzeitstabilität zu überwachenden Versorgungsspannungen führen könnten, werden mit Hilfe der Komponenten der L3-Schicht LL3 detektiert. ROM oder RAM - Fehler werden vorzugsweise zyklisch detektiert. "Aliveness", d.h. Lebendigkeit und periodische Wiederkehr der Vergleichsfunktionen werden geprüft durch Monitoring des Programmablaufs. Die Befehlsverarbeitung im Funktionsrechner wird geprüft durch einen oder mehrere funktionsspezifische Befehlssatztests. So können beispielsweise Codekopien als Testrechnungen benutzt werden oder tatsächliche Berechnungen auf Assembler-Ebene durchgeführt werden. Fehler in der Signalbereitstellung durch den A/D-Wandler können durch Überwachung des A/D-Wandlers detektiert werden.

Dieses Überwachungskonzept für mehrere Versorgungsspannungen eines Mikrocontrollers hat insbesondere folgende Vorteile:
- Es kann in bestehende Monitoring-Konzepte, wie z.B. in das standardisierte E-Gas-Überwachungskonzept von Otto- und Dieselmotoren, eingebettet werden.
- Zusätzlicher Hardware-Aufwand durch spezifische Hardware-Monitoring-Einheiten für jede zu überwachende analoge Versorgungsspannung des Mikrocontrollers ist nicht erforderlich. Dies spart Entwicklungsarbeit und Produktionskosten.
- Trotz des Fehlens eigener externer Hardware-MonitorEinheiten zur Spannungsüberwachung der mehreren analogen Versorgungsspannungen des Mikrocontrollers erlaubt das "softwaremäßige Monitoring" der Versorgungsspannungen nach deren A/D-Wandlung im rechentechnisch abgesicherten Bereich des Funktionsrechners verlässliche Informationen darüber, wie stabil bzw. robust die analogen Versorgungsspannungen des Mikrocontrollers tatsächlich eingehalten werden. Dazu trägt insbesondere die Überwachung dieser digitalisierten Versorgungsspannungen im rechentechnisch abgesicherten Bereich des Mikrocontrollers bei, so dass Auswertefehler der digitalisierten gemessenen Versorgungsspannungen weitgehend vermieden sind. Diese Diagnosesicherheit ist insbesondere vorteilhaft bei Fahrzeug-Steuereinheiten wie z. B. Motorsteuerungen, Getriebesteuerungen oder sonstigen sicherheitsrelevanten Steuergeräten wie z.B. im Chassisbereich, bei denen eine hohe Verfügbarkeit gefordert ist, d.h. ein Ausfall während des Fahrbetriebs nicht tolerabel bzw. unzulässig ist. Allgemein ausgedrückt ist also bei einer Vielzahl praktischer Gegebenheiten eine ausreichende Gesamtverlässlichkeit der Fahrzeug-Steuereinheit weitgehend sichergestellt.
- Verglichen mit reinen Hardware-"Watchdog"-Lösungen erlaubt diese "softwaremäßige Überwachung" der digitalisierten Versorgungsspannungen in einem abgesicherten Rechenbereich des Mikrocontrollers eine höhere Flexibilität, wie z.B. hinsichtlich einzuhaltender Toleranzbereiche bzw. Toleranzbänder für die zu überwachenden Versorgungsspannungen, um eine geeignete Balance bzw. Ausgeglichenheit zwischen Überwachungssicherheit und Verfügbarkeit des Gesamtsystems der Fahrzeug-Steuereinheit weitgehend sicherstellen zu können.
- Insbesondere kann das vorstehend erläuterte Überwachungskonzept innerhalb des VDA-empfohlenen 3-Ebenen-ETC-Monitoring-Konzepts implementiert werden, ohne dass ein zusätzlicher Hardwareaufwand erforderlich wäre.

Im Fall, dass der Mikrocontroller MC mehrere Analog-/DigitalWandler aufweist, werden zweckmäßigerweise alle zu überwachenden Eingangssignale demjenigen Analog-/DigitalWandler zugeführt, dessen Referenzspannung hardwaremäßig spannungsüberwacht wird. Alternativ dazu kann ein Quervergleich der von den verschiedenen Analog-/Digital-Wandlern ausgegebenen Digitalwerte für ein und dasselbe Probensignal durchgeführt werden, wobei ein einzelner spannungsabgesicherter A/D-Wandler als Referenz dient. Die ausgegebenen Digitalwerte für ein und dasselbe Probensignal durch die unterschiedlichen Analog-/Digital-Wandler stehen dann bei einwandfreier Funktionstüchtigkeit der A/D-Wandler im selben Verhältnis wie deren Referenzspannungen zueinander. Ist dies nicht der Fall, so wird dadurch indiziert, dass einer der A/D-Wandler nicht funktionstüchtig ist oder nicht einwandfrei arbeitet.

## Patentansprüche

1. Fahrzeug-Steuereinheit (CD) mit einem Mikrocontroller (MC), an den mehrere analoge Versorgungsspannungen (VCC1 mit VCCn) angelegt sind, und mit einer Überwachungseinheit (MU) zur Funktionsüberwachung des Mikrocontrollers (MC),
wobei der Mikrocontroller (MC) einen A/D-Wandler (ADC1) zur Umwandlung seiner Vielzahl von analogen Versorgungsspannungen (VCC1 mit VCCn) in digitalisierte Versorgungsspannungen umfasst, und dass für die Überwachung dieser digitalisierten Versorgungsspannungen des Mikrocontrollers (MC) ein rechentechnisch abgesicherter Rechenbereich (LL2) im Mikrocontroller (MC) vorgesehen ist, wo die Vielzahl von digitalisierten Versorgungsspannungen dahingehend überwacht sind, ob sie innerhalb vorgegebener Toleranzbereiche (TB1, TB2) liegen, **dadurch gekennzeichnet, dass**
zur Funktionsüberprüfung des Gesamtwertebereichs des A/D-Wandlers (ADC1) des Mikrocontrollers (MC) die Überwachungseinheit (MU) einen redundanten A/D-Wandler (ADC2) aufweist, dessen Eingang mit demselben, sich dynamisch veränderten Referenzsignal (RS) einer Fahrzeugkomponente wie der Eingang des A/D-Wandlers (ADC1) des Mikrocontrollers (MC) beaufschlagt ist, und dass dem abgesicherten Rechenbereich (LL2) des Mikrocontrollers (MC) Digitalwerte des Referenzsignals (RS) vom mit der hardwaremäßig abgesicherten Referenzspannung (RV1) betriebenen A/D-Wandler (ADC1) des Mikrocontrollers (MC) und Digitalwerte des Referenzsignals (RS) vom mit der hardwaremäßig unabgesicherten Referenzspannung (RV2) betriebenen A/D-Wandler (ADC2) der Überwachungseinheit (MU) zum Quervergleich bereitgestellt sind,
und, dass der Mikrokontroller (MC) in einen sicheren Zustand bringbar ist, wenn die Versorgungsspannungen des Mikrocontrollers (MC) außerhalb der vorgegebenen Toleranzbereiche (TB1, TB2) liegen.

2. Fahrzeug-Steuereinheit nach Anspruch 1,
**dadurch gekennzeichnet,**
**dass** der abgesicherte Rechenbereich (LL2) des Mikrocontrollers (MC) eine L2-Schicht (L2) gemäß standardisiertem E-Gas-Überwachungskonzept von Otto- und Dieselmotoren ist.

3. Fahrzeug-Steuereinheit nach einem der vorhergehenden Ansprüche,
**dadurch gekennzeichnet,**
**dass** lediglich für die Versorgungsspannung (VCM) der Überwachungseinheit (MU) eine spezifische, eigene Hardwaremonitoreinheit (MOV) zur Spannungsüberwachung vorgesehen ist.

4. Fahrzeug-Steuereinheit nach Anspruch 3,
**dadurch gekennzeichnet,**
**dass** die mittels der spezifischen Hardwaremonitoreinheit (MOV) hardwaremäßig überwachte Versorgungsspannung (VCM) der Überwachungseinheit (MU) über mindestens einen Spannungsteiler (VD) dem A/D-Wandler (ADC1) des Mikrocontrollers (MC) eine gewünschte Referenzspannung (RV1) bereitstellt.

5. Fahrzeug-Steuereinheit nach einem der vorhergehenden Ansprüche,
**dadurch gekennzeichnet,**
**dass** der A/D-Wandler (ADC1) des Mikrocontrollers (MC) mehrere Referenzspannungen (RV1) zu seinem Betrieb zulässt.

6. Verfahren zur Überwachung mehrerer analoger Versorgungsspannungen (VCC1 mit VCCn), die an den Mikrocontroller (MC) einer Fahrzeug-Steuereinheit (CD) angelegt sind, wobei der Mikrocontroller (MC) mit Hilfe einer zugeordneten Überwachungseinheit (MU) funktionsüberwacht wird, wobei mittels eines A/D-Wandlers (ADC1) des Mikrocontrollers (MC) die Vielzahl von analogen, zu überwachenden Versorgungsspannungen (VCC1 mit VCCn) in digitalisierte Versorgungsspannungen umgewandelt wird, und dass diese digitalisierten Versorgungsspannungen in einem rechentechnisch abgesicherten Rechenbereich (LL2) des Mikrocontrollers (MC) dahingehend überwacht werden, ob sie innerhalb vorgegebener Toleranzbereiche (TB1, TB2) liegen, insbesondere nach einem der vorhergehenden Ansprüche,
**dadurch gekennzeichnet,**
**dass** die Funktion des Gesamtwertebereichs des A/D-Wandlers (ADC1) des Mikrocontrollers(MC) mittels eines redundanten A/D-Wandlers (ADC2) der Überwachungseinheit (MU) überprüft wird, wobei der Eingang des redundanten A/D-Wandlers (ADC2) mit demselben, sich dynamisch veränderten Referenzsignal (RS) einer Fahrzeugkomponente wie der Eingang des A/D-Wandlers (ADC1) des Mikrocontrollers (MC) beaufschlagt wird,
und **dass** dem abgesicherten Rechenbereich (LL2) des Mikrocontrollers (MC) Digitalwerte des Referenzsignals (RS) vom mit der hardwaremäßig abgesicherten Referenzspannung (RV1) betriebenen A/D-Wandler (ADC1) des Mikrocontrollers (MC) und Digitalwerte des Referenzsignals (RS) vom mit der hardwaremäßig unabgesicherten Referenzspannung (RV2) betriebenen A/D-Wandler (ADC2) der Überwachungseinheit (MU) zum Quervergleich bereitgestellt werden, und, dass der Mikrokontroller (MC) in einen sicheren Zustand gebracht werden kann, wenn die Versorgungsspannungen des Mikrocontrollers (MC) außerhalb der vorgegebenen Toleranzbereiche (TB1, TB2) liegen.

## Claims

1. Vehicle control unit (CD) having a microcontroller (MC), to which a plurality of analogue supply voltages (VCC1 with VCCn) are applied, and having a monitoring unit (MU) for monitoring the function of the microcontroller (MC),
the microcontroller (MC) comprising an A/D converter (ADC1) for converting its multiplicity of analogue supply voltages (VCC1 with VCCn) into digitized supply voltages, and a computationally secure computation region (LL2) being provided in the microcontroller (MC) for the purpose of monitoring these digitized supply voltages of the microcontroller (MC), in which computation region the multiplicity of digitized supply voltages are monitored in order to determine whether they are within predefined tolerance ranges (TB1, TB2), **characterized in that**
in order to check the function of the total range of values of the A/D converter (ADC1) of the microcontroller (MC), the monitoring unit (MU) has a redundant A/D converter (ADC2), to the input of which the same dynamically changed reference signal (RS) from a vehicle component as that applied to the input of the A/D converter (ADC1) of the microcontroller (MC) is applied, and **in that** digital values of the reference signal (RS) from the A/D converter (ADC1) of the microcontroller (MC), which is operated using the reference voltage (RV1) which is secure in terms of hardware, and digital values of the reference signal (RS) from the A/D converter (ADC2) of the monitoring unit (MU), which is operated using the reference voltage (RV2) which is not secure in terms of hardware, are made available for the cross-comparison,
and **in that** the microcontroller (MC) can be changed to a safe state when the supply voltages of the microcontroller (MC) are outside the predefined tolerance ranges (TB1, TB2).

2. Vehicle control unit according to Claim 1,
**characterized**
**in that** the secure computation region (LL2) of the microcontroller (MC) is an L2 layer (L2) according to the standardized e-gas monitoring concept of petrol and diesel engines.

3. Vehicle control unit according to one of the preceding claims,
**characterized**
**in that** a specific separate hardware monitoring unit (MOV) for monitoring voltage is provided only for the supply voltage (VCM) of the monitoring unit (MU).

4. Vehicle control unit according to Claim 3,
**characterized**
**in that** the supply voltage (VCM) of the monitoring unit (MU) which is monitored in terms of hardware using the specific hardware monitoring unit (MOV) provides the A/D converter (ADC1) of the microcontroller (MC) with a desired reference voltage (RV1) via at least one voltage divider (VD).

5. Vehicle control unit according to one of the preceding claims,
**characterized**
**in that** the A/D converter (ADC1) of the microcontroller (MC) allows a plurality of reference voltages (RV1) for its operation.

6. Method for monitoring a plurality of analogue supply voltages (VCC1 with VCCn) which are applied to the microcontroller (MC) of a vehicle control unit (CD), the function of the microcontroller (MC) being monitored with the aid of an assigned monitoring unit (MU), the multiplicity of analogue supply voltages (VCC1 with VCCn) to be monitored being converted into digitized supply voltages by means of an A/D converter (ADC1) of the microcontroller (MC), and these digitized supply voltages being monitored in a computationally secure computation region (LL2) of the microcontroller (MC) in order to determine whether they are within predefined tolerance ranges (TB1, TB2), in particular according to one of the preceding claims,
**characterized**
**in that** the function of the total range of values of the A/D converter (ADC1) of the microcontroller (MC) is checked by means of a redundant A/D converter (ADC2) of the monitoring unit (MU), the same dynamically changed reference signal (RS) from a vehicle component as that applied to the input of the A/D converter (ADC1) of the microcontroller (MC) being applied to the input of the redundant A/D converter (ADC2),
and **in that** digital values of the reference signal (RS) from the A/D converter (ADC1) of the microcontroller (MC), which is operated using the reference voltage (RV1) which is secure in terms of hardware, and digital values of the reference signal (RS) from the A/D converter (ADC2) of the monitoring unit (MU), which is operated using the reference voltage (RV2) which is not secure in terms of hardware, are provided for the cross comparison, and in that the microcontroller (MC) can be changed to a safe state when the supply voltages of the microcontroller (MC) are outside the predefined tolerance ranges (TB1, TB2).

## Revendications

1. Unité de commande pour véhicule (CD) comprenant un microcontrôleur (MC) auquel sont appliquées plusieurs tensions d'alimentation analogiques (VCC1 à VCCn), et comprenant une unité de surveillance (MU) destinée à surveiller le fonctionnement du microcontrôleur (MC),
le microcontrôleur (MC) comprenant un convertisseur A/N (ADC1) destiné à convertir sa pluralité de tensions d'alimentation analogiques (VCC1 à VCCn) en tensions d'alimentation numérisées, et que une zone de calcul (LL2) informatiquement sécurisée se trouve dans le microcontrôleur (MC) pour la surveillance de ces tensions d'alimentation numérisées du microcontrôleur (MC), où la pluralité de tensions d'alimentation numérisées sont soumises à une surveillance afin de vérifier qu'elles se trouvent bien dans des plages de tolérance (TB1, TB2) prédéfinies, **caractérisée en ce que** pour le contrôle du fonctionnement de la plage de valeurs totale du convertisseur A/N (ADC1) du microcontrôleur (MC), l'unité de surveillance (MU) possède un convertisseur A/N redondant (ADC2) dont l'entrée est alimentée par le même signal de référence (RS) à variation dynamique d'un composant du véhicule que l'entrée du convertisseur A/N (ADC1) du microcontrôleur (MC), et **en ce que** des valeurs numériques du signal de référence (RS) sont mises à la disposition de la zone de calcul (LL2) sécurisée du microcontrôleur (MC) par le convertisseur A/N (ADC1) du microcontrôleur (MC) fonctionnant avec la tension de référence (RV1) sécurisée matériellement ainsi que des valeurs numériques du signal de référence (RS) par le convertisseur A/N (ADC2) de l'unité de surveillance (MU) fonctionnant avec la tension de référence (RV2) non sécurisée matériellement en vue d'une comparaison croisée,
et **en ce que** le microcontrôleur (MC) peut être amené dans un état sécurisé lorsque les tensions d'alimentation du microcontrôleur (MC) se trouvent en-dehors des plages de tolérance (TB1, TB2) prédéfinies.

2. Unité de commande pour véhicule selon la revendication 1, **caractérisée en ce que** la zone de calcul (LL2) sécurisée du microcontrôleur (MC) est une couche L2 (L2) selon le concept de surveillance E-Gas normalisé des moteurs à essence et diesel.

3. Unité de commande pour véhicule selon l'une des revendications précédentes, **caractérisée en ce qu'**une unité de surveillance matérielle (MOV) spécifique propre destinée à surveiller la tension n'est présente que pour la tension d'alimentation (VCM) de l'unité de surveillance (MU).

4. Unité de commande pour véhicule selon la revendication 3, **caractérisée en ce que** la tension d'alimentation (VCM) de l'unité de surveillance (MU) surveillée matériellement au moyen de l'unité de surveillance matérielle (MOV) spécifique délivre au convertisseur A/N (ADC1) du microcontrôleur (MC) une tension de référence (RV1) souhaitée par le biais d'au moins un diviseur de tension (VD).

5. Unité de commande pour véhicule selon l'une des revendications précédentes, **caractérisée en ce que** le convertisseur A/N (ADC1) du microcontrôleur (MC) autorise plusieurs tensions de référence (RV1) pour son fonctionnement.

6. Procédé de surveillance de plusieurs tensions d'alimentation analogiques (VCC1 à VCCn), lesquelles sont appliquées au microcontrôleur (MC) d'une unité de commande pour véhicule (CD), le fonctionnement du microcontrôleur (MC) étant surveillé à l'aide d'une unité de surveillance (MU) associée, la pluralité de tensions d'alimentation analogiques (VCC1 à VCCn) à surveiller étant converties en tensions d'alimentation numérisées au moyen d'un convertisseur A/N (ADC1) du microcontrôleur (MC), et que ces tensions d'alimentation numérisées sont surveillées dans une zone de calcul (LL2) informatiquement sécurisée du microcontrôleur (MC) afin de vérifier qu'elles se trouvent bien dans des plages de tolérance (TB1, TB2) prédéfinies, notamment selon l'une des revendications précédentes,
**caractérisé en ce que**
le fonctionnement de la plage de valeurs totale du convertisseur A/N (ADC1) du microcontrôleur (MC) est contrôlé au moyen d'un convertisseur A/N redondant (ADC2) de l'unité de surveillance (MU), l'entrée du convertisseur A/N redondant (ADC2) étant alimentée par le même signal de référence (RS) à variation dynamique d'un composant du véhicule que l'entrée du convertisseur A/N (ADC1) du microcontrôleur (MC),
et **en ce que** des valeurs numériques du signal de référence (RS) sont mises à la disposition de la zone de calcul (LL2) sécurisée du microcontrôleur (MC) par le convertisseur A/N (ADC1) du microcontrôleur (MC) fonctionnant avec la tension de référence (RV1) sécurisée matériellement ainsi que des valeurs numériques du signal de référence (RS) par le convertisseur A/N (ADC2) de l'unité de surveillance (MU) fonctionnant avec la tension de référence (RV2) non sécurisée matériellement en vue d'une comparaison croisée,
et **en ce que** le microcontrôleur (MC) peut être amené dans un état sécurisé lorsque les tensions d'alimentation du microcontrôleur (MC) se trouvent en-dehors des plages de tolérance (TB1, TB2) prédéfinies.
